# EUROPÄISCHE PATENTSCHRIFT

(11) **EP 1 929 543 B1**
(45) Veröffentlichungstag und Bekanntmachung des Hinweises auf die Patenterteilung: **20.06.2018**
(21) Anmeldenummer: 06775851.6
(22) Anmeldetag: 14.08.2006
(51) Int. Cl.: H01L 33/58, G02B 27/09

(54) **BELEUCHTUNGSANORDNUNG**
ILLUMINATION ARRANGEMENT
DISPOSITIF D'ÉCLAIRAGE

(30) Priorität: 30.09.2005 DE 102005046941; 23.12.2005 DE 102005061798
(43) Veröffentlichungstag der Anmeldung: 11.06.2008
(73) Patentinhaber: OSRAM Opto Semiconductors GmbH, 93055 Regensburg (DE)
(72) Erfinder: WANNINGER, Mario, 93055 Harting / Regensburg (DE); WILM, Alexander, 93059 Regensburg (DE)
(74) Vertreter: Epping - Hermann - Fischer
(86) Internationale Anmeldenummer: PCT/DE2006/001422
(87) Internationale Veröffentlichungsnummer: WO 2007/036186

(56) Entgegenhaltungen:
- EP-A- 1 213 773
- EP-A- 1 376 708
- EP-A2- 1 653 254
- WO-A-02/052656
- WO-A-2006/089523
- DE-U1- 8 713 875
- US-A1- 2004 207 999

## Beschreibung

Die vorliegende Erfindung betrifft eine Beleuchtungsanordnung mit einer Strahlungsquelle

Die Strahlungsquelle soll oftmals möglichst nahe an einer mit der Beleuchtungsanordnung zu beleuchtenden Fläche positioniert werden. Hierdurch wird zwar einerseits die Ausführung einer Strahlungsquelle-Beleuchtungsflächen-Einheit mit geringer Bautiefe erleichtert. Andererseits aber hängt der von der Strahlungsquelle direkt beleuchtete Teilbereich der Fläche häufig maßgeblich von dem Abstand der Strahlungsquelle von der zu beleuchtenden Fläche ab. Je geringer dieser Abstand ist, desto geringer ist in der Regel die mit der Strahlungsquelle direkt beleuchtete Fläche. Zur Ausleuchtung der gesamten Fläche wird deshalb oftmals eine Mehrzahl von Strahlungsquellen eingesetzt, wobei den einzelnen Strahlungsquellen jeweils ein eigener Beleuchtungsbereich auf der Fläche zugeordnet ist. Um eine geringe Bautiefe der Strahlungsquellen-Beleuchtungsflächen-Einheit zu erzielen, wird somit in Kauf genommen, dass eine Vielzahl von Strahlungsquellen zur flächigen Ausleuchtung eingesetzt werden muss. Häufig könnte jedoch schon eine geringere Anzahl an Strahlungsquellen die für die jeweilige Beleuchtungsanwendung erforderliche Strahlungsleistung liefern.

Aufgabe der vorliegenden Erfindung ist es, eine Beleuchtungsanordnung anzugeben, mit der bei vorgegebenem Abstand einer Auskoppelfläche der Strahlungsquelle von der zu beleuchtenden Fläche, der mittels der Strahlungsquelle beleuchtete Flächenbereich der zu beleuchtenden Fläche vereinfacht vergrößerbar ist.

Diese Aufgabe wird erfindungsgemäß durch eine Beleuchtungsanordnung mit den Merkmalen des Patentanspruchs 1 gelöst. Vorteilhafte Ausgestaltungen und Weiterbildungen der Erfindung sind Gegenstand der abhängigen Ansprüche.

Das Dokument D1 (EP 1 213 773 A1) offenbart eine Beleuchtungsanordnung gemäß dem Oberbegriff des Patentanspruchs 1.

Das Dokument D2 (EP 1 653 254 A2) ist Stand der Technik gemäß Art. 54 (3) EPÜ. Die vorliegende Erfindung ist im Patentanspruch 1 definiert.

Eine erfindungsgemäße Beleuchtungsanordnung umfasst eine Strahlungsemissionsdiode zur Strahlungserzeugung, ein erstes optisches Element zur Strahlformung, ein zweites optisches Element zur Strahlformung und eine optische Achse, die durch die Strahlungsemissionsdiode verläuft. Das erste optische Element weist ebenso wie das zweite optische Element eine Strahlungseintrittsfläche und eine Strahlungsaustrittsfläche auf, wobei die optische Achse durch das erste optische Element und durch das zweite optische Element verläuft. Das erste optische Element ist als Linse ausgeführt und das zweite optische Element ist als Linse ausgeführt. Das erste optische Element und/oder das zweite optische Element enthält einen Kunststoff. Zwischen der Strahlungseintrittsfläche des zweiten optischen Elements und der Strahlungsaustrittsfläche des ersten optischen Elements ist ein mit Gas gefüllter Zwischenraum ausgebildet. Das strahlungsaustrittseitig an das erste optische Element grenzende Medium weist einen geringeren Brechungsindex auf als das Material des ersten optischen Elements. Das strahlungseintrittseitig an das zweite optische Element grenzende Medium weist einen geringeren Brechungsindex auf als das Material des zweiten optischen Elements. Weiterhin bricht die Strahlungsaustrittsfläche des ersten optischen Elements einen Strahlungsanteil an in der Strahlungsemissionsdiode erzeugter Strahlung vor dessen Eintritt in das zweite optische Element, insbesondere gezielt, von der optischen Achse weg. Die Strahlungsaustrittsfläche des zweiten optischen Elements bricht diesen Strahlungsanteil ebenfalls, insbesondere gezielt, von der optischen Achse weg. Die Strahlungsaustrittsfläche des ersten optischen Elements weist einen konkav gekrümmten Teilbereich und einen konvex gekrümmten Teilbereich auf, wobei der konvex gekrümmte Teilbereich den konkav gekrümmten Teilbereich lateral umgibt. Die Strahlungsaustrittsfläche des zweiten optischen Elements weist einen konkav gekrümmten Teilbereich und einen konvex gekrümmten Teilbereich auf, wobei der konvex gekrümmte Teilbereich den konkav gekrümmten Teilbereich lateral umgibt.

Ein derartiges Brechungsverhalten kann durch entsprechende Formgebung der jeweiligen Flächen des ersten beziehungsweise zweiten optischen Elements und entsprechende Anordnung der optischen Elemente relativ zur Strahlungsquelle und untereinander erzielt werden.

Dadurch, dass sowohl das erste optische Element, als auch das zweite optische Element Strahlung gezielt und vorzugsweise gerichtet von der optischen Achse weg brechen, kann der mittels der als Strahlungsquelle dienenden Strahlungsemissionsdiode beleuchtete Bereich der mit der Beleuchtungsanordnung zu beleuchtenden Fläche bei vorgegebenem Abstand der Strahlungsemissionsdiode zu dieser Fläche vereinfacht vergrößert werden. Hierbei sind das erste und das zweite optische Element zweckmäßigerweise zwischen der Strahlungsemissionsdiode und der zu beleuchtenden Fläche angeordnet. Das erste optische Element ist bevorzugt zwischen dem zweiten optischen Element und der Strahlungsemissionsdiode angeordnet.

Über zweimaliges Wegbrechen von Strahlung von der optischen Achse kann weiterhin der in Achsrichtung auf die zu beleuchtende Fläche treffende Anteil an Strahlungsleistung verringert werden. Das Beleuchten der Fläche mit einer homogenen Verteilung der Bestrahlungsstärke - angegeben in Watt der auf die Fläche treffenden Strahlungsleistung pro Quadratmeter der Auftrefffläche - auf dem beleuchteten Bereich der Fläche kann so erleichtert werden. Von besonderem Vorteil ist dies bei einer Strahlungsemissionsdiode als Strahlungsquelle, da eine Strahlungsemissionsdiode in der Regel einen vergleichsweise großen Anteil an Strahlungsleistung in Achsrichtung abstrahlt. Eine homogene und großflächige Ausleuchtung der Fläche in Bereichen, die vergleichsweise weit von der optischen Achse beabstandet sind, mit der Strahlungsemissionsdiode alleine wird hierdurch erschwert.

Eine Strahlungsemissionsdiode zeichnet sich gegenüber herkömmlichen Strahlungsquellen, zum Beispiel Glühlampen, weiterhin durch eine vorteilhafte geringe Bauteilgröße und erhöhte Lebensdauer aus. Die Beleuchtungsanordnung kann somit zuverlässig und kompakt ausgebildet werden.

Bevorzugt ist die Strahlungsemissionsdiode zur Erzeugung elektromagnetischer Strahlung, besonders bevorzugt im infraroten oder ultravioletten Spektralbereich oder als Lichtemissionsdiode, z.B. als LED-Bauelement, zur Strahlungserzeugung, insbesondere inkohärenter Strahlung, im sichtbaren Spektralbereich ausgebildet.

Die Beleuchtungsanordnung ist weiterhin zur Beleuchtung einer ebenen Fläche, zu der die optische Achse bevorzugt senkrecht verläuft, besonders geeignet.

In einer bevorzugten Ausgestaltung ist das erste optische Element zur Strahlaufweitung der in der Strahlungsemissionsdiode erzeugten Strahlung ausgebildet und das zweite optische Element ist zur weitergehenden Strahlaufweitung der durch das erste optische Element hindurchgetretenen Strahlung angeordnet und ausgebildet. Das erste optische Element verbreitet also mit Vorzug die Abstrahlcharakteristik der in der Strahlungsemissionsdiode erzeugten Strahlung, wobei das zweite optische Element die bereits durch das erste optische Element verbreiterte Abstrahlcharakteristik weitergehend verbreitert. Insbesondere kann die Abstrahlcharakteristik der Beleuchtungsanordnung mittels der optischen Elemente vereinfacht gemäß einer vorgegebenen Abstrahlcharakteristik geformt werden. Die Abstrahlcharakteristik wird vorzugsweise derart geformt, dass sich eine homogene laterale Verteilung der Strahlungsleistung auf der mit der Beleuchtungsanordnung beleuchteten Fläche ausbildet.

Hierbei kann ein Winkel des von der optischen Achse weg gebrochenen Strahlungsanteils zur optischen Achse nach dem Durchtritt durch das zweite optische Element größer sein als ein weiterer Winkel dieses Strahlungsanteils zur optischen Achse nach dem Durchtritt durch das erste optische Element und vorzugsweise vor dem Eintritt in das zweite optische Element.

In einer weiteren bevorzugten Ausgestaltung sind die Strahlungsaustrittsfläche des zweiten optischen Elements und die Strahlungsaustrittsfläche des ersten optischen Elements gleichartig geformt. Über eine derartige Formgebung der brechenden Strahlungsaustrittsflächen der optischen Elemente wird das Erzielen einer vorgegebenen Abstrahlcharakteristik auf der Austrittsseite des zweiten optischen Elements erleichtert, da auf eine vergleichsweise aufwändige Abstimmung verschieden geformter Strahlungsaustrittsflächen aufeinander zu diesem Zwecke verzichtet werden kann. Insbesondere können die Strahlungsaustrittsflächen der beiden optischen Elemente geometrisch ähnlich zueinander, das heißt mittels zentrischer Streckung aufeinander abbildbar ausgeführt sein.

Weiterhin kann die Strahlungsein- und/oder -austrittsfläche des zweiten optischen Elements die Strahlungsaustrittsfläche des ersten optischen Elements teilweise oder vollständig überdecken. Die Strahlungsein- und/oder -austrittsfläche des zweiten optischen Elements kann hierbei in einer Richtung senkrecht zur optischen Achse eine laterale Ausdehnung aufweisen, die größer als die der Strahlungsaustrittsfläche des ersten optischen Elements ist. Hierüber wird der Strahlungsübertritt einer vom ersten optischen Element aufgeweiteten Strahlung in das zweite optische Element erleichtert.

Erfindungsgemäß ist die Strahlungsaustrittsfläche des ersten optischen Elements von der Strahlungseintrittsfläche des zweiten optischen Elements beabstandet.

Erfindungsgemäß weist die Strahlungsaustrittsfläche des ersten optischen Elements einen konkav gekrümmten Teilbereich auf und die Strahlungsaustrittsfläche des ersten optischen Elements weist einen konvex gekrümmten Teilbereich auf. Auch das zweite optische Element ist dementsprechend ausgeführt. Eine derartige Formgebung eignet sich besonders für vergleichsweise dünne und somit Platz sparende optische Elemente bei gleichzeitig guter Strahlaufweitung.

Erfindungsgemäß umgibt der konvex gekrümmte Teilbereich den konkav gekrümmten Teilbereich, insbesondere in einem Abstand zur optischen Achse, lateral. Ein derart ausgebildetes optisches Element ist sowohl zur Strahlaufweitung auf geringem Raum, als auch für eine auf der beleuchteten Fläche lateral homogen verteilte Bestrahlungsstärke besonders geeignet.

In einer weiteren vorteilhaften Weiterbildung sind das erste und das zweite optische Element derart angeordnet, dass die optische Achse durch den konkav gekrümmten Teilbereich des ersten optischen Elements und den konkav gekrümmten Teilbereich des zweiten optischen Elements verläuft. Eine zweifache Strahlaufweitung kann so vereinfacht derart erfolgen, dass eine homogene Bestrahlungsstärkeverteilung erzielt wird. Insbesondere gilt dies für vergleichsweise weit von der optischen Achse beabstandete Teilbereiche der zu beleuchtenden Fläche.

In einer weiteren bevorzugten Ausgestaltung weisen die Strahlungsaüstrittsflache des ersten optischen Elements und die Strahlungsaustrittsfläche des zweiten optischen Elements jeweils eine Symmetrieachse, insbesondere eine Rotationssymmetrieachse, auf. Bevorzugt sind das erste optische Element und das zweite optische Element derart angeordnet, dass die Symmetrieachsen der Strahlungsaustrittsflächen übereinstimmen. Besonders bevorzugt sind die beiden optischen Elemente derart angeordnet, dass deren Symmetrieachsen und die optische Achse übereinstimmen. Über derartige Ausführung beziehungsweise Anordnung der -optischen Elemente relativ zueinander- oder bezüglich der Strahlungsemissionsdiode wird eine Homogenisierung der Bestrahlungsstärkeverteilung auf der zu beleuchteten Fläche weitergehend vereinfacht. Aufgrund- der symmetrischen, insbesondere rotationssymmetrischen Ausführung der Strahlungsein- und/oder -austrittsflächen der optischen Elemente oder der -optischen Elemente selbst kann weiterhin vereinfacht eine symmetrische Abstrahlcharakteristik erzielt werden. Das homogene Ausleuchten der Fläche wird in der Folge erleichtert.

In einer weiteren bevorzugten Ausgestaltung weist die Strahlungseintrittsfläche des zweiten optischen Elements eine Ausnehmung auf. Die Strahlungsaustrittsfläche des ersten optischen Elements kann in die Ausnehmung hineinragen. Dies erleichtert eine kompakte Ausführung der Beleuchtungsanordnung.

Weiterhin kann die Ausnehmung in der Strahlungseintrittsfläche des zweiten optischen Elements die Strahlungsaustrittsfläche des ersten optischen Elements teilweise oder vollständig überdecken.

In einer weiteren bevorzugten Ausgestaltung weist die Strahlungseintrittsfläche des zweiten optischen Elements einen konkav gekrümmten Teilbereich auf. Mittels des konkav gekrümmten Teilbereichs der Strahlungseintrittsfläche kann die Ausnehmung gebildet sein. Der konkav gekrümmte Teilbereich kann insbesondere als Freiformfläche, die bevorzugt nicht sphärisch und/oder nicht asphärisch gekrümmt ausgeführt ist, ausgeführt sein.

Der konkav gekrümmte Teilbereich ist gemäß einer vorteilhaften Weiterbildung derart ausgebildet, dass Strahlung aus dem ersten optischen Element im konkav gekrümmten Teilbereich im Wesentlichen senkrecht auf die Strahlungseintrittsfläche des zweiten optischen Elements auftrifft. Eine Brechung am konkav gekrümmten Teilbereich kann aufgrund des formgebungsbedingten senkrechten Auftreffens von Strahlung in diesem Bereich vermieden werden. Die Gefahr einer durch Brechung am konkav gekrümmten Teilbereich verursachten Inhomogenität in der Strahlungsleistungsverteilung auf der beleuchteten Fläche kann über derartige Formgebung verringert werden.

Gemäß einer weiteren vorteilhaften Weiterbildung ist der konkav gekrümmte Teilbereich der Strahlungseintrittsfläche des zweiten optischen Elements als brechende Fläche ausgebildet. Bevorzugt ist der konkav, gekrümmte Teilbereich derart geformt, dass Strahlung beim Eintritt in das zweite optische Element von der optischen Achse weg gebrochen wird. Die Abstrahlcharakteristik der Beleuchtungsanordnung kann so vereinfacht weitergehend verbreitert werden. Hierfür ist eine Ausführung der Strahlungseintrittsfläche des zweiten optischen Elements, insbesondere des konkav gekrümmten Teilbereichs der Strahlungseintrittsfläche, als Freiformfläche, die entsprechend geformt ist, besonders geeignet.

In einer weiteren bevorzugten Ausgestaltung enthält das erste optische Element und/oder das zweite optische Element ein Silikon, ein Silikonharz, ein Silikon-Hybridmaterial, ein PMMA, ein PMMI oder ein Polykarbonat.

Erfindungsgemäß ist zwischen der Strahlungseintrittsfläche des zweiten optischen Elements und der Strahlungsaustrittsfläche des ersten optischen Elements ein Zwischenraum ausgebildet.

Gemäß einer Abwandlung, die nicht Bestandteil der vorliegenden Erfindung ist, ist zwischen der Strahlungseintrittsfläche des zweiten optischen Elements und der Strahlungsaustrittsfläche des ersten optischen Elements ein Brechungsindexanpassungsmaterial angeordnet. Die Gefahr von durch übermäßige Brechungsindexsprünge bedingten Reflexionsverlusten bei der Auskopplung aus dem ersten optischen Element und/oder der Einkopplung von Strahlung in das zweite optische Element wird hierdurch vorteilhaft verringert. Bevorzugt grenzt das Brechungsindexanpassungsmaterial an die Strahlungsaustrittsfläche des ersten und die Strahlungseintrittsfläche des zweiten optischen Elements an. Das Brechungsindexanpassungsmaterial kann zum Beispiel in der Ausnehmung angeordnet sein. Das Brechungsindexanpassungsmaterial vermindert mit Vorzug den Brechungsindexunterschied zwischen den optischen Elementen und dem angrenzenden Medium, zum Beispiel Luft. Ein derartiges Brechungsindexanpassungsmaterial ist dann besonders zweckmäßig, falls Rückreflexionen verringert oder vollständig vermieden werden sollen.

Erfindungsgemäß ist der Zwischenraum zwischen der Strahlungseintrittsfläche des zweiten optischen Elements und der Strahlungsaustrittsfläche des ersten optischen Elements unbefüllt oder, insbesondere im Wesentlichen, frei von einem Brechungsindexanpassungsmaterial. Es ist ein Gas, etwa Luft, im Zwischenraum angeordnet. Eine derartige Ausbildung eignet sich aufgrund des höheren Brechungsindexunterschiedes besonders dann, wenn die Strahlungseintrittsfläche des zweiten optischen Elements, insbesondere deren konkav gekrümmter Teilbereich, wie weiter oben ausgeführt, als brechende Fläche ausgebildet ist. Ferner kann die Brechung an der Strahlungsaustrittsfläche des ersten optischen Elements hierdurch gegenüber einem brechungsindexangepassten Übergang zwischen den optischen Elementen verstärkt werden.

In einer weiteren bevorzugten Ausgestaltung ist zwischen der Strahlungseintrittsfläche des ersten optischen Elements und der Strahlungsemissionsdiode ein Brechungsindexanpassungsmaterial angeordnet. Die optische Anbindung des ersten optischen Elements an die Strahlungsemissionsdiode kann so entsprechend den obigen Ausführungen verbessert werden.

Gemäß einer Abwandlung, die nicht Bestandteil der vorliegenden Erfindung ist, ist zwischen den optischen Elementen ein Brechungsindexanpassungsmaterial und zwischen der Strahlungsemissionsdiode und dem ersten optischen Element ein weiteres Brechungsindexanpassungsmaterial angeordnet. Gemäß einer weiteren vorteilhaften Weiterbildung ist zwischen dem ersten optischen Element und der Strahlungsemissionsdiode ein Brechungsindexanpassungsmaterial angeordnet und der Zwischenraum zwischen der Strahlungsaustrittsfläche des ersten optischen Elements und der Strahlungseintrittsfläche des zweiten optischen Elements unbefüllt oder, insbesondere im Wesentlichen, frei von einem Brechungsindexanpassungsmaterial. Die Abstrahlcharakteristik der Beleuchtungsanordnung kann so aufgrund verstärkter Brechung vereinfacht in besonders hohem Maße verbreitert werden.

In einer weiteren bevorzugten Ausgestaltung ist das erste optische Element in der Strahlungsemissionsdiode integriert. Beispielsweise kann das erste optische Element durch entsprechende Formgebung einer Umhüllung eines Halbleiterchips der Strahlungsemissionsdiode, in die der Halbleiterchip mit Vorzug eingebettet ist, realisiert sein. In einer weiteren bevorzugten Ausgestaltung ist das erste optische Element, insbesondere als separates optisches Element, an der Strahlungsemissionsdiode befestigt. Auch das zweite optische Element kann an der Strahlungsemissionsdiode insbesondere als separates optisches Element, befestigt sein. Die optischen Elemente können so mit Vorteil vergleichsweise unabhängig von der Struktur der Strahlungsemissionsdiode gefertigt sein. Die Beleuchtungsanordnung kann insbesondere als Bauelement mit an der Strahlungsemissionsdiode montiertem ersten und/oder zweiten optischen Element ausgeführt sein.

Eine oberflächenmontierbare Strahlungsemissionsdiode ist ferner für eine kompakte Beleuchtungsanordnung besonders geeignet.

In einer weiteren bevorzugten Ausgestaltung sind das erste optische Element und das zweite optische Element als diskrete optische Elemente ausgeführt. Eine Formgebung der beiden optischen Elemente kann vorteilhafterweise unabhängig voneinander erfolgen.

In einer weiteren bevorzugten Ausgestaltung ist das erste optische Element am zweiten optischen Element vormontiert. Ein derartiger Verbund der beiden optischen Elemente erleichtert die Montage beziehungsweise die Justage der optischen Elemente relativ zur Strahlungsemissionsdiode. Der vormontierte und vorjustierte Verbund kann vereinfacht an der Strahlungsemissionsdiode befestigt und justiert werden.

In einer weiteren bevorzugten Ausgestaltung sind die Strahlungsemissionsdiode und das zweite optische Element auf einem gemeinsamen Trägerelement montiert. Die Strahlungsemissionsdiode und das erste optische Element können alternativ oder zusätzlich auch auf einem derartigen gemeinsamen Trägerelement montiert sein. Insbesondere können das erste optische Element, das zweite optische Element und/oder die Strahlungsemissionsdiode eine gemeinsame Montageebene, etwa die Ebene des Trägerelements, aufweisen. Das Trägerelement kann beispielsweise als Leiterplatte ausgeführt sein. Die einzelnen Elemente der Beleuchtungsanordnung können demnach unabhängig voneinander auf dem Trägerelement montiert werden.

In einer weiteren bevorzugten Ausgestaltung umfasst die Beleuchtungsanordnung eine Mehrzahl von Strahlungsemissionsdioden. Hierdurch kann die zur Beleuchtung zur Verfügung stehende Strahlungsleistung vereinfacht vergrößert werden. Weiterhin kann mittels einer Mehrzahl von Strahlungsemissionsdioden vereinfacht mischfarbiges Licht erzeugt werden.

Hierzu weisen die von den Strahlungsemissionsdioden erzeugten Strahlungen mit Vorteil unterschiedliche, insbesondere verschiedenfarbige, Emissionswellenlängen im sichtbaren Spektralbereich auf. Beispielsweise kann die Beleuchtungsanordnung eine Strahlungsemissionsdiode mit einer Emissionswellenlänge im roten, eine weitere Strahlungsemissionsdiode mit einer Emissionswellenlänge im grünen und eine wiederum weitere Strahlungsemissionsdiode mit einer Emissionswellenlänge im blauen Spektralbereich aufweisen. Bei entsprechender Mischung der Strahlungen ist so Licht verschiedenster Farben, insbesondere auch weißes Licht, erzeugbar.

In einer weiteren bevorzugten Ausgestaltung ist den Strahlungsemissionsdioden jeweils ein eigenes erstes optisches Element und ein eigenes zweites optisches Element zugeordnet. Das Erreichen einer homogenen Bestrahlungsstärkeverteilung wird über eine derartige Zuordnung erleichtert. Die ersten optischen Elemente sind bevorzugt an der jeweiligen zugeordneten Strahlungsemissionsdiode befestigt.

In einer weiteren bevorzugten Ausgestaltung ist den Strahlungsemissionsdioden jeweils ein eigenes erstes Element und ein einzelnes gemeinsames zweites optisches Element zugeordnet. Dies erleichtert die Anordnung des zweiten optischen Elements relativ zu den ersten optischen Elementen.

Den ersten optischen Elementen können weiterhin jeweils eigene zweite optische Elemente zugeordnet sein. Die Strahlformung gemäß einer vorgegebenen Abstrahlcharakteristik kann in der Folge vereinfacht werden.

In einer weiteren bevorzugten Ausgestaltung ist eine Mehrzahl von zweiten optischen Elementen in einer Vorrichtung integriert ausgeführt. Gegebenenfalls können auch die ersten optischen Elemente in einer weiteren Vorrichtung integriert ausgeführt sein. Die Justage einer derartigen Vorrichtung kann gegenüber einer getrennten Justage der optischen Elemente vereinfacht erfolgen. Bevorzugt sind die optischen Elemente in der Vorrichtung gemäß einer vorgegebenen Anordnung der Strahlungsemissionsdioden in der Beleuchtungsanordnung angeordnet und ausgebildet.

In einer weiteren bevorzugten Ausgestaltung ist die Beleuchtungsanordnung zur, insbesondere direkten, Hinterleuchtung einer Anzeigevorrichtung, etwa eines LCDs (LCD: Liquid Crystal Display), vorgesehen.

Weiterhin ist die Beleuchtungsanordnung für eine direkte Beleuchtung besonders geeignet.

Weitere Merkmale, Vorteile und Zweckmäßigkeiten der Erfindung ergeben sich aus der folgenden Beschreibung der Ausführungsbeispiele in Verbindung mit den Figuren.
Figur 1 zeigt eine schematische Schnittansicht eines ersten Ausführungsbeispiels einer erfindungsgemäßen Beleuchtungsanordnung,
Figur 2 zeigt die Abstrahlcharakteristik einer erfindungsgemäßen Beleuchtungsanordnung,
Figur 3 zeigt die Abstrahlcharakteristik einer Beleuchtungsanordnung mit lediglich einem optischen Element,
Figur 4 zeigt eine schematische Schnittansicht eines zweiten Ausführungsbeispiels einer erfindungsgemäßen Beleuchtungsanordnung,
Figur 5 zeigt eine schematische Schnittansicht eines dritten Ausführungsbeispiels einer erfindungsgemäßen Beleuchtungsanordnung,
Figur 6 zeigt eine schematische Schnittansicht eines vierten Ausführungsbeispiels einer erfindungsgemäßen Beleuchtungsanordnung,
Figur 7 zeigt ein als Strahlungsemissionsdiode für die Beleuchtungsanordnung besonders geeignetes optoelektronisches Bauteil 2 anhand einer schematischen perspektivischen Aufsicht auf das Bauteil in Figur 7A und einer perspektivischen schematischen Schnittansicht des Bauteils in Figur 7B,
Figur 8 zeigt eine schematische perspektivische Schrägaufsicht auf eine Strahlungsemissionsdiode,
Figur 9 zeigt in den Figuren 9A und 9B schematische Schrägaufsichten eines für eine Beleuchtungsanordnung besonders geeignetes optisches Element und
Figur 10 zeigt eine schematische perspektivische Schrägaufsicht eines fünften Ausführungsbeispiels einer erfindungsgemäßen Beleuchtungsanordnung.

Gleiche, gleichartige und gleich wirkende Elemente sind in den Figuren mit gleichen Bezugszeichen versehen.

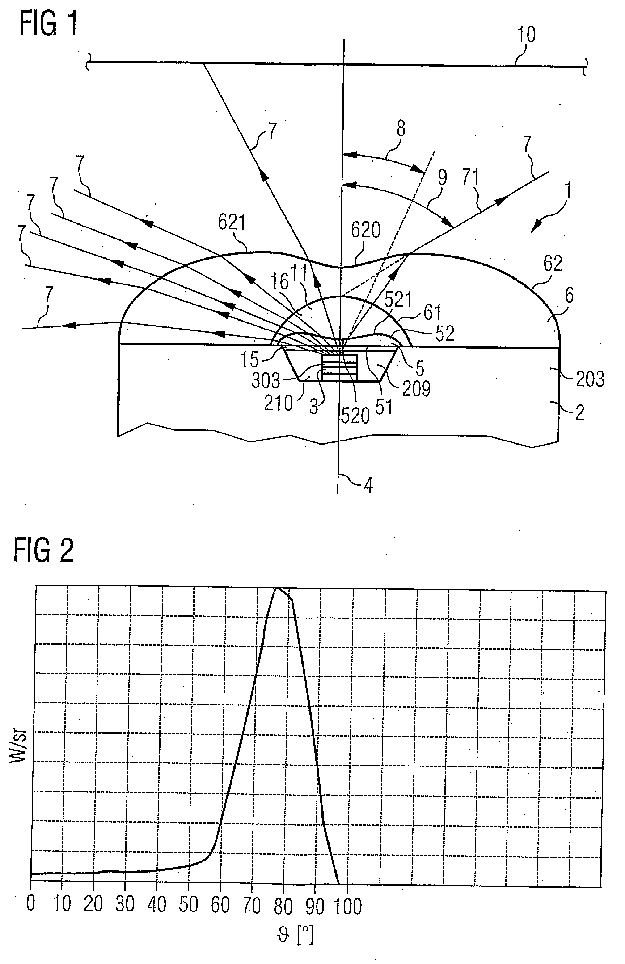

Figur 1 zeigt eine schematische Schnittansicht eines ersten Ausführungsbeispiels einer erfindungsgemäßen Beleuchtungsanordnung 1.

Die Beleuchtungsanordnung 1 umfasst eine Strahlungsemissionsdiode 2, die einen Halbleiterchip 3 zur Strahlungserzeugung aufweist. Eine optische Achse 4 verläuft durch die Strahlungsemissionsdiode und insbesondere den Halbleiterchip. Die optische Achse 4 kann beispielsweise im Wesentlichen senkrecht zum Halbleiterchip 3, bevorzugt senkrecht zu einer zur Strahlungserzeugung vorgesehenen aktiven Zone 303 des Halbleiterchips, verlaufen. Ein erstes optisches Element 5 und ein zweites optisches Element 6 der Beleuchtungsanordnung 1, die jeweils als Linse ausgeführt sind, weisen jeweils eine Strahlungseintrittsfläche 51 bzw. 61 und eine Strahlungsaustrittsfläche 52 bzw. 62 auf. Die optische Achse 4 verläuft durch das erste optische Element 5 und das zweite optische Element 6.

Das erste und das zweite optische Element sind derart angeordnet und ausgebildet, dass im Halbleiterchip 3 erzeugte Strahlung 7 beim Austritt aus dem ersten optischen Element mittels dessen Strahlungsaustrittsfläche 52 gezielt und gerichtet von der optischen Achse 4 weg gebrochen wird. Das strahlungsaustrittsseitig an das erste optische Element angrenzende Medium weist hierzu zweckmäßigerweise, wie zum Beispiel Luft, einen geringeren Brechungsindex auf als das Material des ersten optischen Elements. Nachfolgend tritt die Strahlung 7 über die Strahlungseintrittsfläche 61 in das zweite optische Element 6 ein. Das Material des zweiten optischen Elements 6 weist gegenüber dem seitens dessen Strahlungseintrittsfläche an das zweite optische Element angrenzenden Medium, zum Beispiel Luft, bevorzugt einen höheren Brechungsindex auf. Beim Austritt über die Strahlungsaustrittsfläche 62 des zweiten optischen Elements 6 wird die Strahlung ebenfalls von der optischen Achse 4 weg gebrochen.

Dies ist anhand des Strahlungsanteils 71 verdeutlicht. Ein Winkel 8 dieses Strahlungsanteils zur optischen Achse 4 nach dem Durchtritt durch das erste optische Element 5 und vor dem Eintritt in das zweite optische Element 6 ist kleiner als ein weiterer Winkel 9 dieses Strahlungsanteils zur optischen Achse nach dem Durchtritt durch das zweite optische Element.

Das erste und das zweite optische Element 5 und 6 sind jeweils zur Strahlaufweitung der im Halbleiterchip 3 erzeugten Strahlung 7 ausgebildet, wobei die durch das erste optische Element 5 hindurch getretene, bereits voraufgeweitete Strahlung mittels des zweiten optischen Elements 6 weitergehend aufgeweitet wird. Die Abstrahlcharakteristik der Beleuchtungsanordnung 1 wird dadurch gegenüber derjenigen des Halbleiterchips 3 bzw. derjenigen der Strahlungsemissionsdiode 2 zweifach verbreitert.

Bei einem vorgegebenen Abstand einer Auskoppelfläche der Beleuchtungsanordnung 1, die im vorliegenden Ausführungsbeispiel durch die Strahlungsaustrittsfläche 62 des zweiten optischen Elements 6 gebildet ist, wird über Brechung mittels des ersten und des zweiten optischen Elements der durch die Beleuchtungsanordnung beleuchtete Teilbereich einer zu beleuchtenden, insbesondere ebenen, Fläche 10 vergrößert. Umgekehrt kann bei einem beleuchteten Teilbereich eines vorgegebenen Flächeninhalts aufgrund der Mehrzahl an gezielt brechenden Strahlungsaustrittsflächen, der Abstand der Auskoppelfläche der Beleuchtungsanordnung zur Fläche 10 verringert werden.

Ferner ist die Beleuchtungsanordnung 1 zur homogenen Ausleuchtung der Fläche 10 ausgebildet. Die optischen Elementen 5 und 6 sind hierzu derart angeordnet und ausgebildet, dass eine vorgegebene Abstrahlcharakteristik der Beleuchtungsanordnung erzielt wird, die eine homogen verlaufende Strahlungsleistungsverteilung auf dem beleuchteten Teilbereich der Fläche 10 bewirkt. Hierzu weisen die Strahlungsaustrittsflächen 52 und 62 der optischen Elemente jeweils einen konkav gekrümmten Teilbereich 520 bzw. 620 auf, durch den die optische Achse 4 verläuft. Den jeweiligen konkav gekrümmten Teilbereich 520 oder 620 umgibt in einem Abstand zur optischen Achse 4 ein konvex gekrümmter Teilbereich 521 bzw. 621. Über eine derartige Formgebung der Strahlungsaustrittsflächen der optischen Elemente kann der mittels der in der Strahlungsemissionsdiode 2 erzeugten Strahlung 7 beleuchtete Bereich der Fläche 10 vereinfacht vergrößert werden, wobei zugleich eine lateral homogene Verteilung der Strahlungsleistung auf der beleuchteten Fläche erzielt wird. Inhomogenitäten in der Strahlungsleistungsverteilung, das heißt Bereiche, in denen die Strahlungsleistung von derjenigen in benachbarten Bereichen der beleuchteten Fläche erheblich abweicht, können so vermieden werden. Ferner ist die Homogenität der Strahlungsleistungsverteilung bei derartiger Formgebung der optischen Elemente mit Vorteil unabhängig vom Abstand der Auskoppelfläche der Beleuchtungsanordnung zur Fläche 10. Bei einer Abstandsänderung der Fläche 10 relativ zur Auskoppelfläche treten somit keine Inhomogenitäten auf.

Strahlformung in den optischen Elementen 5 und/oder 6 kann totalreflexionsfrei und insbesondere ausschließlich über brechende Flächen erfolgen. Weiterhin kann die Strahlungsaustrittsfläche des jeweiligen optischen Elements oder die optischen Funktionsflächen des jeweiligen optischen Elements können kantenfrei ausgeführt sein. Die Strahlungsaus- oder -eintrittsflächen können jeweils als differenzierbare Flächen ausgeführt sein. Insgesamt wird so das Ausbilden einer homogenen Strahlungsleistungsverteilung erleichtert.

Die Strahlungsaustrittsflächen 521 bzw. 621 des ersten optischen Elements 5 und des zweiten optischen Elements 6 sind zudem gleichartig geformt. Eine homogene, großflächige Ausleuchtung der Fläche 10 wird so erleichtert.

Die optischen Elemente 5 und 6 für sich genommen wären schon für eine homogene Ausleuchtung geeignet, wobei mittels einer Mehrzahl von optischen Elementen mit gleichartig geformten Strahlungsaustrittsflächen die Abstrahlcharakteristik vereinfacht weitergehend verbreitert werden kann.

Für eine homogene symmetrische Bestrahlungsstärkeverteilung auf der Fläche 10 sind die Strahlungsaustrittsflächen 52 bzw. 62, insbesondere die optischen Elemente 5 und 6, bevorzugt rotationssymmetrisch ausgebildet und derart angeordnet, dass die jeweilige Rotationssymmetrieachse und die optische Achse 4 aufeinander liegen.

Hierzu sei angemerkt, dass sich eine rotationssymmetrische Ausgestaltung der optischen Elemente im wesentlichen auf die optischen Funktionsflächen, das heißt die zur Strahlformung vorgesehenen Elemente des optischen Elements bezieht. Elemente, die hauptsächlich nicht der Strahlformung dienen, müssen nicht notwendigerweise rotationssymmetrisch ausgeführt sein.

Bevorzugt weist der konvex gekrümmte Teilbereich des ersten und/oder zweiten optischen Elements eine Krümmung auf die kleiner ist, als eine Krümmung des konkav gekrümmten Teilbereichs. Ferner kann der Flächeninhalt des konvex gekrümmten Teilbereichs 621 bzw. 521 der Strahlungsaustrittsfläche 52 bzw. 62 größer sein als der des konkav gekrümmten Teilbereichs 620 bzw. 520. Vergleichsweise weit von der optischen Achse entfernte Bereiche der Fläche 10 können so vereinfacht mittels der Beleuchtungsanordnung 1 beleuchtet werden. Weiterhin kann der konvex gekrümmte Teilbereich der jeweiligen Strahlungsaustrittsfläche einen ersten und einen zweiten Bereich aufweisen, wobei die Krümmung des ersten Bereichs kleiner ist als die Krümmung des zweiten Bereichs. Bevorzugt ist der zweite Bereich weiter von der optischen Achse oder dem konkav gekrümmten Teilbereich entfernt als. der erste Bereich. Hierdurch kann der unter einem vergleichsweise großen. Winkel zur optischen Achse über den stärker gekrümmten zweiten Bereich aus dem bzw. den optischen Elementen austretende Strahlungsanteil erhöht werden.

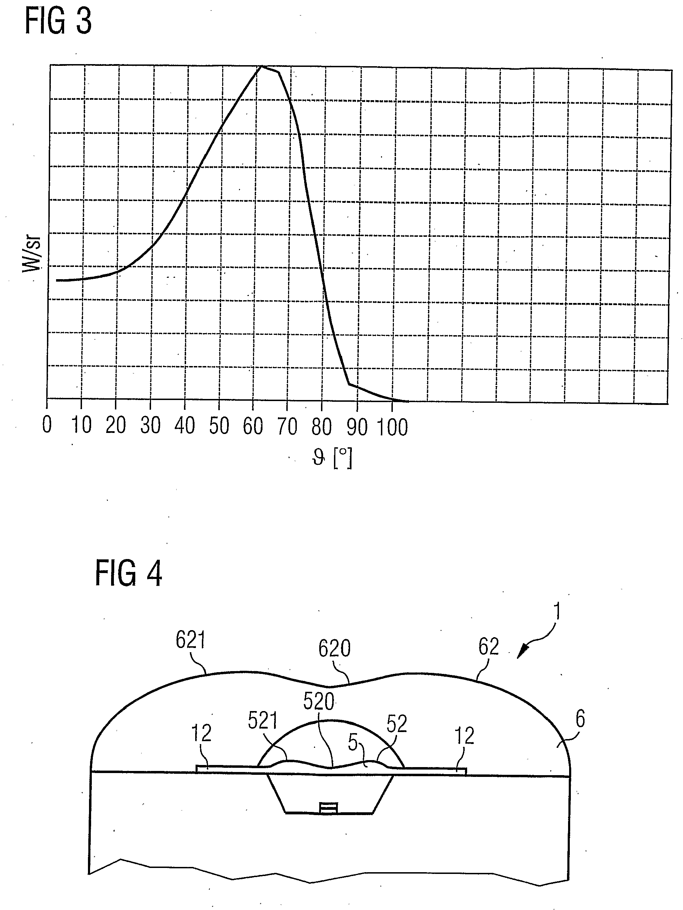

Anhand der Figuren 2 und 3 wird verdeutlicht, wie die Abstrahlcharakteristik der Beleuchtungsanordnung mittels des ersten und des zweiten optischen Elements verbreitert wird.

Figur 2 zeigt die Abstrahlcharakteristik einer Beleuchtungsanordnung 1 gemäß Figur 1, während Figur 3 die Abstrahlcharakteristik einer Beleuchtungsanordnung gemäß Figur 1 mit lediglich einem optischen Element, zum Beispiel dem zweiten optischen Element 6, zeigt. Aufgetragen ist die jeweils die Abhängigkeit der von der Beleuchtungsanordnung abgegebenen Strahlungsleistung pro Raumwinkel (in W/sr) vom Winkel ϑ zur optischen Achse. Die optischen Elemente sind rotationssymmetrisch zur optischen Achse ausgebildet und die Abstrahlcharakteristik ist demgemäß rotationssymmetrisch zu ϑ = 0°. Gemäß Figur 2 ist die Strahlstärke in Achsrichtung gegenüber Figur 3 stark verringert und die Abstrahlcharakteristik der Beleuchtungsanordnung wird zusätzlich verbreitert. Die Beleuchtungsanordnung 1 gemäß Figur 1 strahlt insbesondere im wesentlichen senkrecht zur optischen Achse, obwohl der Halbleiterchip 3 bzw. die Strahlungsemissionsdiode 2 den Großteil der Strahlungsleistung in Achsrichtung abgibt. Weiterhin strahlt die Beleuchtungsanordnung gemäß Figur 1 auch in den rückwärtigen Halbraum, das heißt ein maßgeblicher Strahlungsanteil verlässt die Beleuchtungsanordnung unter einem Winkel ϑ größer 90 Grad zur optischen Achse. Die optischen Elemente verteilen die von der Strahlungsemissionsdiode erzeugte Strahlung demnach seitlich. Die in einem Topemitter, wie der Strahlungsemissionsdiode, erzeugte Strahlung kann durch die optischen Elemente derart geformt werden, dass die Beleuchtungsanordnung im wesentlichen seitlich abstrahlt.

Die Strahlungsaustrittsfläche 52 des ersten optischen Elements 5 ist im Ausführungsbeispiel gemäß Figur 1 in einer Ausnehmung 11 der Strahlungseintrittsfläche 61 des zweiten optischen Elements 6 angeordnet. Die Ausnehmung 11 ist als, insbesondere asphärisch, konkav gekrümmter Teilbereich der Strahlungseintrittsfläche 61 ausgeführt. Die Strahlungseintrittsfläche ist, insbesondere im Bereich der Ausnehmung und/oder des strahlungseintrittsseitigen konkav gekrümmten Teilbereichs als Freiformfläche ausgeführt.

Die Krümmung kann, derart gewählt werden, dass aus dem ersten optischen Element 5 austretende Strahlung im Bereich der Ausnehmung 11 senkrecht auf die Strahlungseintrittsfläche 61 des zweiten optischen Elements 6 trifft. Eine Brechung an der Strahlungseintrittsfläche 61 kann so zumindest gemindert oder vermieden werden. Die Abstimmung der optischen Elemente aufeinander zur homogenen Ausleuchtung der Fläche 10 wird hierdurch vereinfacht.

Alternativ kann die Strahlungseintrittsfläche, insbesondere im Bereich der Ausnehmung, als brechende Fläche, die Strahlung beim Eintritt in das zweite optische Element von der optischen Achse weg bricht, ausgeführt sein. Im Hinblick auf ein verstärktes Wegbrechen von Strahlung von der optischen Achse ist diese Ausgestaltung der Strahlungseintrittsfläche des zweiten optischen Elements bevorzugt.

Die Ausnehmung 11 überdeckt die Strahlungsaustrittsfläche 52 des ersten optischen Elements 5 lateral vollständig. Weiterhin umgibt das zweite optische Element 6 das erste optisch Element lateral umfangseitig Der Strahlungsübertritt von Strahlung aus dem ersten in das zweite optische Element wird so erleichtert.

Der Halbleiterchip 3 der Strahlungsemissionsdiode 2 ist bevorzugt in einer Kavität 209 eines Gehäusekörpers 203 der Strahlungsemissionsdiode 2 angeordnet. Eine Umhüllung 210, in die der Halbleiterchip 3 weiterhin bevorzugt eingebettet ist, schützt diesen vor schädlichen äußeren Einflüssen. Beispielsweise enthält die Umhüllung ein Reaktionsharz, etwa ein Acryl- oder Epoxidharz, ein Silikonharz, ein Silikon oder ein Silikon-Hybridmaterial. Der Halbleiterchip 3 kann beispielsweise mit der Umhüllung umgossen sein.

Silikonhaltige Materialien, wie ein Silikonharz, ein Silikon oder ein Silikon-Hybridmaterial, zeichnen sich durch hohe Stabilität in den optischen Eigenschaft bei dauerhafter Bestrahlung mit hochenergetischer, kurzwelliger, z.B. blauer oder ultravioletter, Strahlung, die der Halbleiterchip 3 bevorzugt erzeugen kann, aus. Insbesondere kann die Gefahr einer Vergilbung, Trübung oder Verfärbung der Umhüllung durch den Einsatz silikonbasierter Materialien, insbesondere gegenüber einer Umhüllung, die ein Reaktionsharz enthält, verringert werden.

Ein Silikon-Hybridmaterial enthält mit Vorteil neben einem Silikon noch ein weiteres Material. Ein Silikon-Hybridmaterial kann beispielsweise ein Silikon und ein Reaktionsharz, z.B. ein Epoxidharz, enthalten. Hierüber kann die mechanische Stabilität des, insbesondere gehärteten, Silikon-Hybridmaterials gegenüber einem nicht hybridisierten Silikon erhöht werden.

Die Strahlungsemissionsdiode 2 ist vorzugsweise als oberflächenmontierbares Bauteil ausgeführt. Auf eine Darstellung der Anschlussleiter des Bauteils sowie der elektrischen Kontaktierung des Halbleiterchips wurde in Figur 1 aus Gründen der Übersichtlichkeit verzichtet.

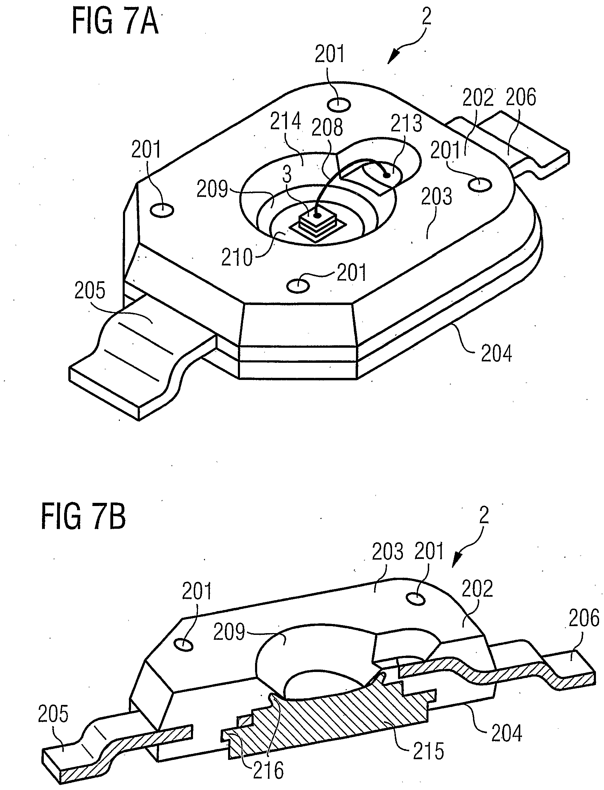

Das erste optische Element 5 und das zweite optische Element 6 sind im Ausführungsbeispiel gemäß Figur 1 als diskrete optische Elemente ausgeführt. Bevorzugt sind das erste und das zweite optische Element an der Strahlungsemissionsdiode, insbesondere deren Gehäusekörper, befestigt. Beispielsweise sind die optischen Elemente jeweils auf die Strahlungsemissionsdiode aufgeklebt oder aufgesteckt. Aufkleben eignet sich besonders für das erste optische Elemente während Aufstecken für das zweite optische Element besonders geeignet ist. Für die Befestigung sind am optischen Element bevorzugt Befestigungselemente angebracht oder im optischen Element integriert ausgebildet, die in korrespondierende Befestigungsvorrichtungen, die an der Strahlungsemissionsdiode, insbesondere im Gehäusekörper, ausgebildet sein können, eingreifen (vergleiche hierzu die Figuren 7 bis 10).

Das erste optische Element 5 kann vor der Anbringung des zweiten optischen Elements 6 an der Strahlungsemissionsdiode 2 befestigt oder gegebenenfalls in der Strahlungsemissionsdiode integriert sein. Eine Integration in der Strahlungsemissionsdiode kann beispielsweise durch entsprechende Formgebung der Umhüllung 210, etwa beim Gießen der Umhüllung, realisiert sein.

Zwischen der Strahlungseintrittsfläche 51 des ersten optischen Elements 5 und der Strahlungsemissionsdiode 2, insbesondere deren Halbleiterchip 3, kann ein Brechungsindexanpassungsmaterial 15 angeordnet sein. Übermäßige Brechungsindexsprünge mit einhergehender erhöhter Reflexion an Grenzflächen können so vermindert werden. Beispielsweise ist das Brechungsindexanpassungsmaterial 15 zwischen der Umhüllung 210 und der Strahlungseintrittsfläche 51 des ersten optischen Elements 5 angeordnet und grenzt vorzugsweise an diese an. Für das Brechungsindexanpassungsmaterial 15 eignet sich besonders ein Silikon, insbesondere ein Silikongel.

Das erste optische Element und/oder das zweite optische Element enthält einen Kunststoff, z.B. ein Silikon, ein Silikonharz, ein Silikon-Hybridmaterial, ein PMMA (PMMA: Polymethylmethacrylat), ein PMMI (PMMI: Polyacrylesterimid) oder ein Polykarbonat. Ein, insbesondere gehärtetes, Silikonhybrid kann sich gegenüber einem, insbesondere nicht hybridisierten und vorzugsweise gehärteten, Silikon durch erhöhte mechanische Stabilität auszeichnen.

Für das erste optische Element eignet sich besonders ein Silikon, ein Silikonharz oder ein Silikon-Hybridmaterial. Dies gilt im Besonderen hinsichtlich optimierter Strahlungsbeständigkeit und/oder im Hinblick auf die optimierte Brechungsindexanpassung zur Strahlungsemissionsdiode, falls die Umhüllung 210 ein Silikon oder ein Material auf Silikonbasis enthält und/oder die Brechungsindexanpassung des ersten optischen Elements an die Strahlungsemissionsdiode über ein silikonhaltiges Material, z.B. ein Silikongel, erfolgt.

Ein weiteres Brechungsindexanpassungsmaterial 16 kann in der Ausnehmung 11 zwischen der Strahlungseintrittsfläche 61 des zweiten optischen Elements 6 und der Strahlungsaustrittsfläche 52 des ersten optischen Elements 5 angeordnet sein. Für das Brechungsindexanpassungsmaterial 16 eignet sich besonders, ein Silikon, insbesondere ein Silikongel. In diesem Falle enthält das zweite optische Element im Hinblick auf vereinfachte gute Brechungsindexanpassung bevorzugt ein Silikon oder ein Silikon-Hybridmaterial.

Für eine starke Brechung an der Strahlungsaustrittsfläche 52 des ersten optischen Elements und bevorzugt der Strahlungseintrittsfläche 61 des zweiten optischen Elements, was vorliegend bevorzugt ist, ist auf eine Brechungsindexanpassung der optischen Elemente 5 und 6 aneinander zweckmäßigerweise verzichtet. Demnach ist in der Ausnehmung 11 bevorzugt ein Gas, beispielsweise Luft, angeordnet, das einen für die Brechung vorteilhaft hohen Brechungsindexunterschied herstellt. Das zweite optische Element enthält hierbei, etwa im Hinblick auf besonders hohe mechanische Stabilität, vorzugsweise kein Silikon oder silikonbasiertes Material, sondern z.B. ein Polykarbonat.

Weiterhin kann die Strahlungseintrittsfläche des ersten optischen Elements und/oder diejenige des zweiten optischen Elements mit einer Mikrostruktur oder einer Mottenaugenstruktur versehen sein. Rückreflexionen, etwa Fresnel-Reflexionen, können so gemindert werden. Derartige Strukturen können in einem für das optische Element formgebenden Werkzeug, etwa einer Gussform, insbesondere einer Spritzgießform, ausgebildet sein.

Die Beleuchtungsanordnung 1 eignet sich besonders zur, insbesondere direkten, Hinterleuchtung von Anzeigevorrichtungen, etwa Symbolen oder eines LCD, bei geringer Gesamtbaugröße. Im Straßenverkehrsbereich kann die Beleuchtungsanordnung zur Umgebungsbeleuchtung im Fahrzeuginnenraum, bei Straßenverkehrssignalen, wie Begrenzungsleuchten, zum Beispiel in Tunnels, bei Rundumkennleuchten, zum Beispiel für Einsatzfahrzeuge, oder bei der homogenen Ausleuchtung von Reflektoren bei geringer Gesamtbautiefe eingesetzt werden.

Auch in der Allgemeinbeleuchtung kann die Beleuchtungsanordnung Anwendung finden. So zum Beispiel bei der Effektbeleuchtung von Decken, Böden oder Wänden oder bei der Umgebungsbeleuchtung. Auch zum großflächigen Einkoppeln in einen auf die Beleuchtungsanordnung aufgesetzten Lichtleiter oder zum seitlichen Einkoppeln in einen Lichtleiter ist die Beleuchtungsanordnung geeignet. Für die vorgenannten Anwendungen eignet sich besonders eine Beleuchtungsanordnung, die sichtbare Strahlung emittiert.

Eine infrarote Strahlung emittierende Beleuchtungsanordnung kann zum Beispiel bei einer Lichtschranke oder einem Lichtvorhang Anwendung finden. Auch bei Sender-Empfängereinheiten, zum Beispiel zur Erkennung ob der Beifahrersitzplatz besetzt ist oder als Sonnenstandssensor, kann die Anordnung eingesetzt werden. Bei Detektoranwendungen ist der Halbleiterchip zweckmäßigerweise zum Strahlungsempfang vorgesehen bzw. die Diode ist als Photodiode ausgebildet. Die optischen Elemente erleichtern dann den Strahlungsempfang aus einem großen Raumwinkelbereich.

Figur 4 zeigt eine schematische Schnittansicht eines zweiten Ausführungsbeispiels einer erfindungsgemäßen Beleuchtungsanordnung 1. Dieses Ausführungsbeispiel entspricht im wesentlichen dem in Figur 1 gezeigten. Im Unterschied hierzu ist das erste optische Element 5 am zweiten optischen Element 6 vormontiert. Beispielsweise sind das erste und das zweite optische Element verklebt. Der Elementverbund kann dann an der Strahlungsemissionsdiode befestigt werden. Für die Vormontage weist das erste optische Element 5 ein oder eine Mehrzahl von Montageelementen 12 auf, mittels derer die Vormontage erfolgen kann. Die Montageelemente können beispielsweise Montageflächen, zum Beispiel Klebeflächen, zur Verfügung stellen. Zweckmäßigerweise erfolgt die Vormontage außerhalb der optischen Funktionsbereiche der optischen Elemente. Der konvex gekrümmte Teilbereich 521 der Strahlungsaustrittsflächen des ersten optischen Elements ist zwischen den Montageelementen 12 und seinem konkav gekrümmten Teilbereich 520 angeordnet.

Das Montageelement ist bevorzugt im ersten optischen Element 5 integriert. Ein einzelnes Montageelement kann die Strahlungsaustrittsflächen 52, beispielsweise ringartig, lateral umlaufen.

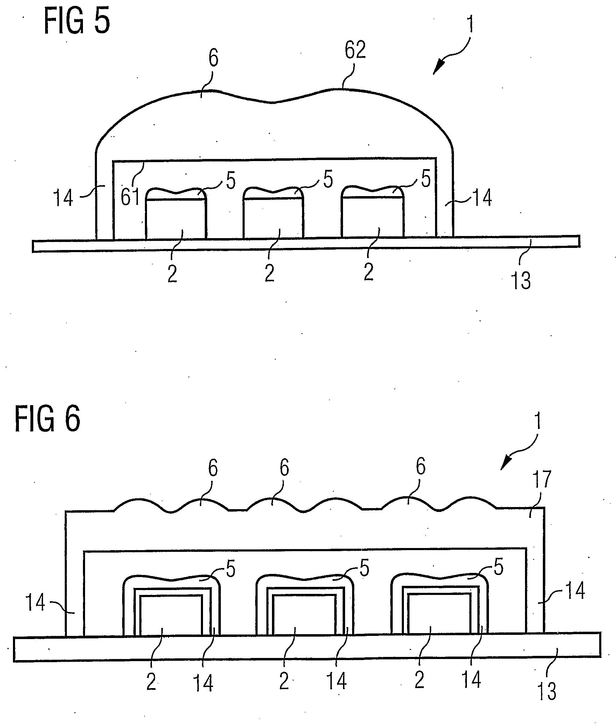

In den Figuren 5 und 6 ist eine schematische Schnittansicht eines dritten bzw. eines vierten Ausführungsbeispiels einer erfindungsgemäßen Beleuchtungsanordnung dargestellt.

Die Beleuchtungsanordnung 1 umfasst eine Mehrzahl von Strahlungsemissionsdioden 2, zum Beispiel drei Strahlungsemissionsdioden, die vorzugsweise verschiedenfarbiges Licht erzeugen, zum Beispiel rotes, grünes bzw. blaues Licht. Die Beleuchtungsanordnung kann so mischfarbiges Licht verschiedenster Farben erzeugen.

In Figur 5 ist den Strahlungsemissionsdioden 2 jeweils ein eigenes diskretes erstes optisches Element 5 zugeordnet, während den Strahlungsemissionsdioden 2 ein gemeinsames 5 zweites optisches Element 6 zugeordnet ist. Die ersten optischen Elemente 5 sind bevorzugt gleichartig ausgeführt. Die Strahlungseintrittsfläche 61 des zweiten optischen Elements überdeckt die ersten optischen Elemente 5. Ferner sind die Strahlungsemissionsdioden 2 und das zweite optische Element 6 auf einem gemeinsamen Trägerelement 13, etwa einer Leiterplatte, wie einem PCB (PCB: printed circuit board) montiert. Das zweite optische Element 6 und die Strahlungsemissionsdiode 2 sind direkt auf dem Trägerelement montiert und weisen insbesondere eine gemeinsame Montageebene auf. Hierzu weist das zweite optische Element Montagestege 14 auf, die sich bevorzugt von der Strahlungseintrittsfläche 61 in Richtung des Trägerelements 13 erstrecken. Die Montagestege 14 sind bevorzugt lateral neben den beiden äußersten Strahlungsemissionsdioden der Beleuchtungsanordnung angeordnet. Die Montagestege umgreifen also bevorzugt die Strahlungsemissionsdioden. Weiterhin ist das zweite optische Element lateral von den Strahlungsemissionsdioden beabstandet.

In Figur 6 sind den einzelnen Strahlungsemissionsdioden 2 im Unterschied zu Figur 5 jeweils eigene erste und zweite optische Elemente 5 bzw. 6, die bevorzugt, insbesondere hinsichtlich der Strahlungsaustrittsflächen, jeweils gleichartig ausgeführt sind, zugeordnet. Die optischen Elemente 5 und 6 sind mit den Strahlungsemissionsdioden 2 auf einem gemeinsamen Trägerelement 13 montiert. Das erste und/oder zweite optische Element und die Strahlungsemissionsdiode können eine gemeinsame Montageebene aufweisen. Weiterhin weisen die ersten optischen Elemente Montagestege 14 auf. Bevorzugt umgreifen die Montagestege des jeweiligen ersten optischen Elements zur Montage auf dem Trägerelement die dem jeweiligen optischen Element 5 zugeordnete Strahlungsemissionsdiode. Das erste optische Element ist weiterhin mit Vorzug lateral von der dem optischen Element zugeordneten Strahlungsemissionsdiode beabstandet. Zwischen der Strahlungsemissionsdiode und dem optischen Element kann insbesondere ein umlaufender Freiraum gebildet sein.

Die zweiten optischen Elemente 6 sind dabei in einer Vorrichtung 17, z.B. einer Optikplatte, integriert. Gegebenenfalls können auch die ersten optischen Elemente 5 in einer weiteren Vorrichtung integriert sein. Die Vorrichtung ist mit Vorzug einstückig ausgeführt.

In Figur 7 ist ein als Strahlungsemissionsdiode für die Beleuchtungsanordnung besonders geeignetes optoelektronisches Bauteil 2 anhand einer schematischen perspektivischen Aufsicht auf das Bauteil in Figur 7A und einer perspektivischen schematischen Schnittansicht des Bauteils in Figur 7B dargestellt.

Ein derartiges optoelektronische Bauteil ist beispielsweise in WO 02/084749 näher beschrieben. Als Strahlungsemissionsdiode ist ein Bauteil ähnlich dem mit der Typenbezeichnung LW W5SG (Hersteller: Osram Opto Semiconductors GmbH), ein damit verwandtes oder ein ähnliches Bauteil des gleichen Herstellers besonders geeignet.

Das optoelektronische Bauteil 2 umfasst einen ersten elektrischen Anschlussleiter 205 und einen zweiten elektrischen Anschlussleiter 206, die aus verschiedenen Seitenflächen des Gehäusekörpers 203 des optoelektronischen Bauteils 2 herausragen können und beispielsweise schwingenartig ausgebildet sind. Das Bauteil ist insbesondere als oberflächenmontierbares optoelektronisches Bauteil ausgeführt.

Der Gehäusekörper 203 weist eine Kavität 209 auf, in der der Halbleiterchip 3 angeordnet ist. Der Halbleiterchip 3 ist in eine Umhüllung 210 eingebettet. Der Halbleiterchip 3 ist weiterhin mit dem Anschlussleiter 205, beispielsweise mittels einer Lötverbindung, elektrisch leitend verbunden. Eine leitende Verbindung zum zweiten Anschlussleiter 206 wird vorzugsweise über einen Bonddraht 208 hergestellt. Der elektrische Anschluss des Bonddrahts an den zweiten Anschlussleiter 206 erfolgt mit Vorzug im Bereich einer Ausbuchtung 213 einer Wand 214 der Kavität 209.

Der Halbleiterchip 3 ist auf einem thermischen Anschlussteil 215 angeordnet, das als Chipträger fungiert. Das thermische Anschlussteil erstreckt sich in vertikaler Richtung mit Vorzug von der Kavität 209 bis zur zweiten Hauptfläche 204 des Gehäusekörpers 203 und erleichtert einen, insbesondere gegenüber der Chipmontagefläche auf dem thermischen Anschlussteil, großflächigen thermischen Anschluss des Halbleiterchips 3 seitens der zweiten Hauptfläche an eine externe Wärmeleitvorrichtung, etwa einen Kühlkörper, z.B. aus Cu. Die thermische Belastung des Gehäusekörpers kann so, insbesondere bei einem Betrieb des Bauteils als Hochleistungsbauteil, mit Vorteil verringert werden. Das optoelektronische Bauteil kann zur Erzeugung einer hohen Strahlungsleistung bei einer gleichzeitig aufgrund des thermischen Anschlussteils vorteilhaft verbesserten Wärmeableitung ausgebildet sein. Ein derartiges optoelektronisches Bauteil ist für eine Beleuchtungsanordnung besonders geeignet.

Das thermische Anschlussteil 215 ist beispielsweise in eine Lasche des ersten Anschlussleiters 205 eingeknüpft oder anderweitig mit dem ersten Anschlussleiter, insbesondere elektrisch leitend und/oder mechanisch, lateral umfangsseitig verbunden. Der zweite Anschlussleiter 206, der zur Kontaktierung mit dem Bonddraht 208 vorgesehen ist, ist vorzugsweise bezüglich der Chipmontage-Ebene des Halbleiterchips 3 auf dem thermischen Anschlussteil 215 erhöht. Die für eine Reflexion von Strahlung zur Verfügung stehende Fläche der Wand der Kavität wird so vorteilhaft groß gehalten. Der Gehäusekörper 203 kann beispielsweise aus einem gut reflektierenden Material, zum Beispiel weißer Kunststoff, gefertigt sein. Gegebenenfalls kann der Gehäusekörper, insbesondere im Bereich der Kavität, mit einem reflexionssteigernden Material, zum Beispiel einem geeigneten Metall/beschichtet sein. Weiterhin kann das thermische Anschlussteil 215 selbst reflektierend ausgeführt sein und bildet dann mit Vorzug einen Teil des Bodens und/oder der Wand der Kavität 209. Das thermische Anschlussteil kann ferner seitens der zweiten Hauptfläche aus dem Gehäusekörper herausragen oder im wesentlichen eben mit dem Gehäusekörper abschließen. Beispielsweise enthält das thermische Anschlussteil ein Metall hoher Wärmeleitfähigkeit, etwa Cu oder Al, oder eine Legierung, etwa eine CuW-Legierung.

Ein Leiterrahmen mit den beiden Anschlussleitern 205 und 206 und dem thermischen Anschlussteil 215 kann bei der Herstellung eines derartigen optoelektronischen Bauteils in einem geeigneten Gussverfahren, etwa einem Spritzgussverfahren, mit dem Material des Gehäusekörpers, z.B. einem Kunststoff, umformt werden. Der Halbleiterchip wird nach der Herstellung des Gehäusekörpers am bzw. in dem Premolded-Gehäuse angeordnet. Das thermische Anschlussteil 215 ist vorzugsweise mit einer oder mehreren Ausbuchtungen oder Auswölbungen 216 ausgebildet, wodurch die mechanische Anbindung des thermischen Anschlussteils an den Gehäusekörper verbessert und somit die Gesamtstabilität des optoelektronischen Bauteils erhöht wird.

Seitens einer ersten Hauptfläche 202 des Gehäusekörpers sind Befestigungsvorrichtungen 201 ausgebildet, die zur Befestigung eines optischen Elements vorgesehen sind, wobei das optische Element beispielsweise das erste oder zweite optische Element entsprechend den weiter oben beschriebenen Ausführungsbeispielen bilden kann. Zur Befestigung des optischen Elements am Gehäusekörper 203 können beispielsweise vier Befestigungsvorrichtungen 201 vorgesehen sein, die eine mechanisch stabile Befestigung des optischen Elements am Bauteil erleichtern. Zweckmäßigerweise sind die Befestigungsvorrichtungen 201 in den Eckbereichen der ersten Hauptfläche 202 des Gehäusekörpers 203 angeordnet. Die Befestigungsvorrichtungen können sich als Aussparungen von der ersten Hauptfläche in den Gehäusekörper hinein erstrecken. Bevorzugt erstrecken sich die Befestigungsvorrichtungen bis zur zweiten Hauptfläche des Gehäusekörpers.

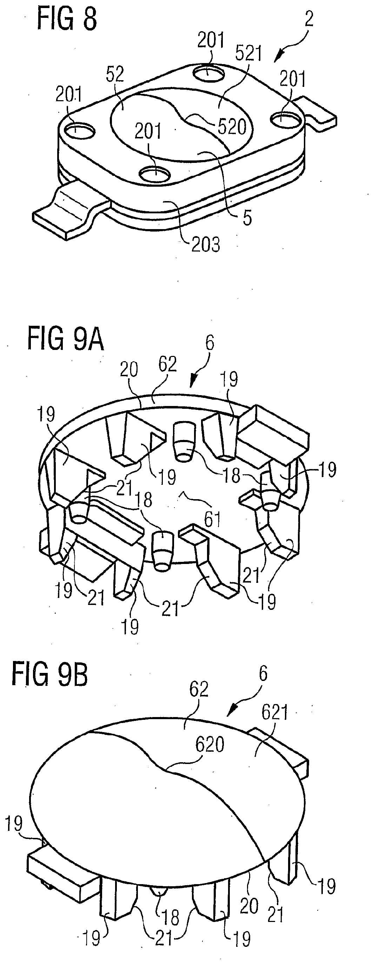

Figur 8 zeigt eine schematische perspektivische Schrägaufsicht auf eine Strahlungsemissionsdiode 2, die ähnlich der in der Figur 7 gezeigten ausgebildet ist. An der Strahlungsemissionsdiode 2 ist das erste optische Element 5, dessen Strahlungsaustrittsfläche 52 den konkav gekrümmten Teilbereich 520 und den konvex gekrümmten Teilbereich 521 aufweist, befestigt. Beispielsweise ist das erste optische Element 5 auf die Strahlungsemissionsdiode 2 aufgeklebt. Nachfolgend kann das zweite optische Element an der Strahlungsemissionsdiode 2 befestigt werden. Beispielsweise kann das zweite optische Element auf die Strahlungsemissionsdiode 2 aufgesteckt werden, wobei bevorzugt Befestigungselemente des optischen Elements in die Befestigungsvorrichtungen 201 der Strahlungsemissionsdiode 2 eingreifen. Die Befestigungsvorrichtungen 201 sind vorzugsweise als den Gehäusekörper vollständig durchdringende Aussparungen, die lateral durch Material des Gehäusekörpers umgeben sind, ausgebildet.

Figur 9 zeigt anhand der Figuren 9A und 9B ein für eine Strahlungsemissionsdiode 2, insbesondere eine, die gemäß den in den Figuren 7 oder 8 gezeigten ausgebildet ist, besonders geeignetes zweites optisches Element 6. Das gezeigte optische Element eignet sich gegebenenfalls alternativ oder zusätzlich auch als erstes optisches Element. Figur 9A zeigt eine schematische Schrägaufsicht auf die Strahlungseintrittsfläche 61 und Figur 9B eine schematische Schrägaufsicht auf die Strahlungsaustrittsfläche 62 des optischen Elements 6. Das optische Element 6 weist eine Mehrzahl von Befestigungselementen 18, die beispielsweise stiftartig ausgebildet sind, auf. Diese Befestigungselemente können in die Befestigungsvorrichtungen 201 der Strahlungsemissionsdiode 2 gemäß Figur 7 oder 8 eingreifen. Hierbei kann das optische Element beispielsweise mittels Presspassung an der Strahlungsemissionsdiode befestigt werden. Gegebenenfalls kann alternativ oder zusätzlich für eine Verklebung noch ein Klebstoff auf die Befestigungselemente 18 aufgebracht werden. Die Befestigungselemente 18 sind an der Strahlungseintrittsfläche 61 des optischen Elements angebracht oder im optischen Element integriert. Das optische Element und die Befestigungselemente können demnach einstückig ausgeführt sein. Ferner weist das zweite optische Element 6 eine Mehrzahl von Führungselementen 19 auf, die randseitig angeordnet sind. Diese erleichtern, insbesondere maschinelle, das Aufsetzen bzw. Aufstecken des optischen Elements 6 auf die Strahlungsemissionsdiode 2. Hierzu sind die Befestigungselemente auf einer dem Rand 20 des optischen Elements abgewandten Seite mit einer Abschrägung 21 versehen. Beim Aufsetzen des optischen Elements 6 auf die Strahlungsemissionsdiode 2 treten die Führungselemente vorzugsweise mit dem Gehäusekörper 203 der Strahlungsemissionsdiode in direkten mechanischen Kontakt, wobei die Abschrägungen 21 derart ausgebildet sind, dass die Befestigungselemente 18 bei leicht degustiertem Aufsetzen bezüglich der Befestigungsvorrichtungen 201 den Befestigungsvorrichtungen 201 zugeführt werden.

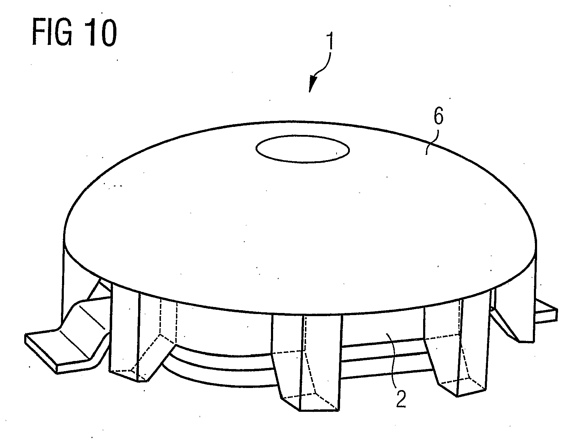

Die Strahlungseintrittsfläche 61 kann bei den in den Figuren 5, 6 und 9 gezeigten optischen Elementen gegebenenfalls einen konkav gekrümmten Teilbereich entsprechend den in den Figuren 1 und 4 gezeigten zweiten optischen Elementen 6 aufweisen. Figur 10 zeigt eine schematische perspektivische Schrägansicht eines fünften Ausführungsbeispiels einer erfindungsgemäßen Beleuchtungsanordnung 1 mit der Strahlungsemissionsdiode 2, die z.B. gemäß Figur 8 ausgebildet und mit einem ersten optischen Element 5 versehen ist und auf die das zweite optische Element 6 aufgesteckt ist.

## Patentansprüche

1. Beleuchtungsanordnung (1), die eine Strahlungsemissionsdiode (2) zur Strahlungserzeugung, ein erstes optisches Element (5) zur Strahlformung, ein zweites optisches Element (6) zur Strahlformung und eine optische Achse (4), die durch die Strahlungsemissionsdiode verläuft, umfasst, wobei
- das erste optische Element eine Strahlungseintrittsfläche (51) und eine Strahlungsaustrittsfläche (52) aufweist,
- das zweite optische Element eine Strahlungseintrittsfläche (61) und eine Strahlungsaustrittsfläche (62) aufweist,
- die optische Achse durch das erste optische Element und das zweite optische Element verläuft,
- das erste optische Element (5) als Linse ausgeführt ist und das zweite optische Element (6) als Linse ausgeführt ist,
- das erste optische Element (5) und/oder das zweite optische Element (6) einen Kunststoff enthält,
- zwischen der Strahlungseintrittsfläche (61) des zweiten optischen Elements (6) und der Strahlungsaustrittsfläche (52) des ersten optischen Elements (5) ein mit Gas gefüllter Zwischenraum ausgebildet ist,
- das strahlungsaustrittseitig an das erste optische Element (5) grenzende Medium einen geringeren Brechungsindex aufweist als das Material des ersten optischen Elements (5),
- das strahlungseintrittseitig an das zweite optische Element (6) grenzende Medium einen geringeren Brechungsindex aufweist als das Material des zweiten optischen Elements (6),
- die Strahlungsaustrittsfläche des ersten optischen Elements einen Strahlungsanteil (71) an in der Strahlungsemissionsdiode erzeugter Strahlung (7) vor dessen Eintritt in das zweite optische Element von der optischen Achse weg bricht und
- die Strahlungsaustrittsfläche des zweiten optischen Elements diesen Strahlungsanteil von der optischen Achse weg bricht, **dadurch gekennzeichnet, dass**
- die Strahlungsaustrittsfläche (52) des ersten optischen Elements (5) einen konkav gekrümmten Teilbereich (520) und einen konvex gekrümmten Teilbereich (521) aufweist, wobei der konvex gekrümmte Teilbereich (521) den konkav gekrümmten Teilbereich (520) lateral umgibt,
- die Strahlungsaustrittsfläche (62) des zweiten optischen Elements (6) einen konkav gekrümmten Teilbereich (620) und einen konvex gekrümmten Teilbereich (621) aufweist, wobei der konvex gekrümmte Teilbereich (621) den konkav gekrümmten Teilbereich (620) lateral umgibt.

2. Beleuchtungsanordnung nach Anspruch 1,
**dadurch gekennzeichnet, dass**
das erste optische Element (5) zur Strahlaufweitung der in der Strahlungsemissionsdiode erzeugten Strahlung ausgebildet ist und das zweite optische Element zur weitergehenden Strahlaufweitung (6) der durch das erste optische Element hindurchgetretenen Strahlung angeordnet und ausgebildet ist.

3. Beleuchtungsanordnung nach Anspruch 1 oder 2,
**dadurch gekennzeichnet, dass**
ein Winkel (9) des Strahlungsanteils (71) zur optischen Achse (4) nach dem Durchtritt durch das zweite optische Element größer ist als ein weiterer Winkel (8) des Strahlungsanteils zur optischen Achse nach dem Durchtritt durch das erste optische Element und vor dem Eintritt in das zweite optische Element.

4. Beleuchtungsanordnung nach mindestens einem der vorhergehenden Ansprüche, **dadurch gekennzeichnet, dass** die optische Achse (4) durch den konkav gekrümmten Teilbereich (520) der Strahlungsaustrittsfläche (52) des ersten optischen Elements (5) und durch den konkav gekrümmten Teilbereich (620) der Strahlungsaustrittsfläche (62) des zweiten optischen Elements (6) verläuft.

5. Beleuchtungsanordnung nach mindestens einem der vorhergehenden Ansprüche,
**dadurch gekennzeichnet, dass**
die Strahlungsaustrittsfläche (52) des ersten optischen Elements (5) und diejenige (62) des zweiten optischen Elements (6) jeweils eine Symmetrieachse aufweisen.

6. Beleuchtungsanordnung nach Anspruch 5,
**dadurch gekennzeichnet, dass**
das erste optische Element (5) und das zweite optische Element (6) derart angeordnet sind, dass die Symmetrieachsen der Strahlungsaustrittsflächen (52, 62) übereinstimmen.

7. Beleuchtungsanordnung nach Anspruch 5,
**dadurch gekennzeichnet, dass**
die beiden optischen Elemente (5, 6) derart angeordnet sind, dass die Symmetrieachsen der Strahlungsaustrittsflächen (52, 62) und die optische Achse (4) übereinstimmen.

8. Beleuchtungsanordnung nach mindestens einem der vorhergehenden Ansprüche,
**dadurch gekennzeichnet, dass**
die Strahlungseintrittsfläche (61) des zweiten optischen Elements (6) eine Ausnehmung (11) aufweist und die Strahlungsaustrittsfläche (52) des ersten optischen Elements (5) in die Ausnehmung hineinragt.

9. Beleuchtungsanordnung nach Anspruch 8,
**dadurch gekennzeichnet, dass**
die Ausnehmung (11) die Strahlungsaustrittsfläche (52) des ersten optischen Elements (5) teilweise oder vollständig überdeckt.

10. Beleuchtungsanordnung nach mindestens einem der vorhergehenden Ansprüche,
**dadurch gekennzeichnet, dass**
die Strahlungseintrittsfläche (61) des zweiten optischen Elements (6) einen, insbesondere als Freiformfläche ausgeführten, konkav gekrümmten Teilbereich aufweist.

## Claims

1. An illuminating arrangement (1) comprising a radiation-emitting diode (2) for generating radiation, a first optical element (5) for beam shaping, a second optical element (6) for beam shaping and an optical axis (4) running through the radiation emitting diode , wherein
- the first optical element comprises a radiation entrance surface (51) and a radiation exit surface (52),
- the second optical element comprises a radiation entrance surface (61) and a radiation exit surface (62),
- the optical axis runs through the first optical element and the second optical element,
- the first optical element (5) is designed as a lens and the second optical element (6) is designed as a lens,
- the first optical element (5) and/or the second optical element (6) contains a plastic,
- a gas-filled gap is formed between the radiation entrance surface (61) of the second optical element (6) and the radiation exit surface (52) of the first optical element (5),
- the medium bordering the first optical element (5) on the radiation exit side has a lower refractive index than the material of the first optical element (5),
- the medium bordering the second optical element (6) on the radiation entrance side has a lower refractive index than the material of the second optical element (6),
- the radiation exit surface of the first optical element purposely refracts away from the optical axis a radiation portion (71) of radiation (7) generated in the radiation-emitting diode before said radiation portion enters the second optical element and
- the radiation exit surface of the second optical element purposely refracts said radiation portion away from the optical axis, **characterized in that**
- the radiation exit surface (52) of the first optical element (5) has a concavely curved subregion (520) and a convexly curved subregion (521), wherein the convexly curved subregion (521) laterally surrounds the concavely curved subregion (520),
- the radiation exit surface (62) of the second optical element (6) has a concavely curved subregion (620) and a convexly curved subregion (621), wherein the convexly curved subregion (621) laterally surrounds the concavely curved subregion (620).

2. Illuminating arrangement according to claim 1,
**characterized in that**
the first optical element (5) is designed for beam widening of the radiation generated in the radiation-emitting diode and the second optical element is arranged and configured for further beam widening (6) of the radiation transmitted through the first optical element.

3. Illuminating arrangement according to claim 1 or 2,
**characterized in that**
an angle (9) of the radiation portion (71) relative to the optical axis (4) after passing through the second optical element is greater than a further angle (8) of the radiation portion relative to the optical axis after passing through the first optical element and before entering the second optical element.

4. Illuminating arrangement according to at least one of the preceding claims, **characterized in that**
the optical axis (4) runs through the concavely curved subregion (520) of the radiation exit surface (52) of the first optical element (5) and through the concavely curved subregion (620) of the radiation exit surface (62) of the second optical element (6).

5. Illuminating arrangement according to at least one of the preceding claims,
**characterized in that**
the radiation exit surface (52) of the first optical element (5) and that (62) of the second optical element (6) each have an axis of symmetry.

6. Illuminating arrangement according to claim 5,
**characterized in that**
the first optical element (5) and the second optical element (6) are arranged such that the axes of symmetry of the radiation exit surfaces (52, 62) coincide.

7. Illuminating arrangement according to claim 5,
**characterized in that**
the two optical elements (5, 6) are arranged such that the axes of symmetry of the radiation exit surfaces (52, 62) and the optical axis (4) coincide.

8. Illuminating arrangement according to at least one of the preceding claims,
**characterized in that**
the radiation entrance surface (61) of the second optical element (6) has a recess (11) and the radiation exit surface (52) of the first optical element (5) projects into the recess.

9. Illuminating arrangement according to claim 8,
**characterized in that**
the recess (11) partially or completely covers the radiation exit surface (52) of the first optical element (5).

10. Illuminating arrangement according to at least one of the preceding claims,
**characterized in that**
the radiation entrance surface (61) of the second optical element (6) has a concavely curved subregion, in particular designed as a free-form surface.

## Revendications

1. Agencement d'éclairage (1) qui comprend une diode émettrice de rayonnement (2) destinée à générer un rayonnement, un premier élément optique (5) destiné à former un faisceau, un deuxième élément optique (6) destiné à former un faisceau, et un axe optique (4) qui s'étend à travers la diode émettrice de rayonnement, dans lequel
- le premier élément optique présentant une surface d'entrée de rayonnement (51) et une surface de sortie de rayonnement (52),
- le deuxième élément optique présentant une surface d'entrée de rayonnement (61) et une surface de sortie de rayonnement (62),
- l'axe optique s'étendant à travers le premier élément optique et le deuxième élément optique,
- le premier élément optique (5) étant réalisé comme lentille et le deuxième élément optique (6) étant réalisé comme lentille,
- le premier élément optique (5) et/ou le deuxième élément optique (6) contenant une matière plastique,
- un espace intermédiaire rempli de gaz étant réalisé entre la surface d'entrée de rayonnement (61) du deuxième élément optique (6) et la surface de sortie de rayonnement (52) du premier élément optique (5),
- le milieu adjacent au premier élément optique (5) côté sortie du rayonnement présentant un indice de réfraction inférieur à la matière du premier élément optique (5),
- le milieu adjacent au deuxième élément optique (6) côté entrée du rayonnement présentant un indice de réfraction inférieur à la matière du deuxième élément optique (6),
- la surface de sortie de rayonnement du premier élément optique réfractant une fraction de rayonnement (71) de rayonnement (7) généré dans la diode émettrice de rayonnement avant son entrée dans le deuxième élément optique de manière éloignée de l'axe optique, et
- la surface de sortie de rayonnement du deuxième élément optique réfractant cette fraction de rayonnement de manière éloignée de l'axe optique, **caractérisé en ce que**
- la surface de sortie de rayonnement (52) du premier élément optique (5) présente une zone partielle (520) courbée de manière concave et une zone partielle (521) courbée de manière convexe, la zone partielle (521) courbée de manière convexe entourant latéralement la zone partielle (520) courbée de manière concave,
- la surface de sortie de rayonnement (62) du deuxième élément optique (6) présente une zone partielle (620) courbée de manière concave et une zone partielle (621) courbée de manière convexe, la zone partielle (621) courbée de manière convexe entourant latéralement la zone partielle (620) courbée de manière concave.

2. Agencement d'éclairage selon la revendication 1,
**caractérisé en ce que**
le premier élément optique (5) est réalisé pour l'élargissement du faisceau du rayonnement généré dans la diode émettrice de rayonnement et **en ce que** le deuxième élément optique est disposé et réalisé pour l'élargissement supplémentaire du faisceau (6) du rayonnement traversé à travers le premier élément optique.

3. Agencement d'éclairage selon la revendication 1 ou 2,
**caractérisé en ce qu'**
un angle (9) de la fraction de rayonnement (71) par rapport à l'axe optique (4) est supérieur, après le passage à travers le deuxième élément optique, à un angle (8) supplémentaire de la fraction de rayonnement par rapport à l'axe optique après le passage à travers le premier élément optique et avant l'entrée dans le deuxième élément optique.

4. Agencement d'éclairage selon au moins l'une quelconque des revendications précédentes, **caractérisé en ce que** l'axe optique (4) s'étend à travers la zone partielle (520) courbée de manière concave de la surface de sortie de rayonnement (52) du premier élément optique (5) et à travers la zone partielle (620) courbée de manière concave de la surface de sortie de rayonnement (62) du deuxième élément optique (6).

5. Agencement d'éclairage selon au moins l'une quelconque des revendications précédentes,
**caractérisé en ce que**
la surface de sortie de rayonnement (52) du premier élément optique (5) et celle (62) du deuxième élément optique (6) présentent respectivement un axe de symétrie.

6. Agencement d'éclairage selon la revendication 5,
**caractérisé en ce que**
le premier élément optique (5) et le deuxième élément optique (6) sont disposés de manière à ce que les axes de symétrie des surfaces de sortie de rayonnement (52, 62) coïncident.

7. Agencement d'éclairage selon la revendication 5,
**caractérisé en ce que**
les deux éléments optiques (5, 6) sont disposés de manière à ce que les axes de symétrie des surfaces de sortie de rayonnement (52, 62) et l'axe optique (4) coïncident.

8. Agencement d'éclairage selon au moins l'une quelconque des revendications précédentes,
**caractérisé en ce que**
la surface d'entrée de rayonnement (61) du deuxième élément optique (6) présente un évidement (11) et **en ce que** la surface de sortie de rayonnement (52) du premier élément optique (5) fait saillie dans l'évidement.

9. Agencement d'éclairage selon la revendication 8,
**caractérisé en ce que**
l'évidement (11) recouvre en partie ou totalement la surface de sortie de rayonnement (52) du premier élément optique (5).

10. Agencement d'éclairage selon au moins l'une quelconque des revendications précédentes,
**caractérisé en ce que**
la surface d'entrée de rayonnement (61) du deuxième élément optique (6) présente une zone partielle courbée de manière concave, notamment réalisée en tant que surface à forme libre.
